Europäisches Patentamt

European Patent Office

Office européen des brevets

(11) Numéro de publication: **0 455 530 B1**

## FASCICULE DE BREVET EUROPEEN

(45) Date de publication de fascicule du brevet: **17.11.94** (51) Int. Cl.5: **G01C 19/72**

(21) Numéro de dépôt: **91401003.8**

(22) Date de dépôt: **16.04.91**

(54) **Dispositif de mesure à fibre optique, gyromètre, centrale de navigation et de stabilisation, capteur de courant.**

(30) Priorité: **17.04.90 FR 9004908**

(43) Date de publication de la demande:
**06.11.91 Bulletin 91/45**

(45) Mention de la délivrance du brevet:
**17.11.94 Bulletin 94/46**

(84) Etats contractants désignés:
**AT BE CH DE DK ES FR GB GR IT LI LU NL SE**

(56) Documents cités:
**EP-A- 0 168 292**
**GB-A- 2 152 207**

(73) Titulaire: **PHOTONETICS S.A.**
**52, Avenue de l'Europe**
**F-78160 Marly le Roi (FR)**

(72) Inventeur: **Lefevre, Hervé**
**19 Rue des Cordelières**
**F-75013 Paris (FR)**
Inventeur: **Martin, Philippe**
**5 Clos Blaise Cendrars**
**F-78760 Ponchartrain (FR)**

(74) Mandataire: **Harlé, Robert et al**
**c/o Cabinet Harlé & Phélip**
**21, rue de la Rochefoucauld**
**F-75009 Paris (FR)**

Rank Xerox (UK) Business Services
(3.10/3.09/3.3.3)

## Description

L'invention concerne un dispositif de mesure à fibre optique permettant de mesurer la variation d'un paramètre qui produit des perturbations non réciproques dans un interféromètre en anneau de SAGNAC.

L'interféromètre de SAGNAC et les phénomènes physiques qu'il met en jeu sont bien connus. Dans un tel interféromètre une lame séparatrice ou autre dispositif séparateur divise une onde incidente. Les deux ondes contra-propagatives ainsi créées se propagent en sens opposés le long d'un chemin optique fermé, se recombinent et produisent des interférences qui dépendent du déphasage des ondes lors de leur recombinaison.

A l'origine, le chemin optique fermé des interféromètres de SAGNAC était défini par des miroirs. Il est maintenant connu qu'il peut être constitué par une bobine multi-tour de fibre optique monomode.

Il est également connu que certains phénomènes physiques sont susceptibles de produire des perturbations, particulièrement des déphasages, non réciproques, sur les ondes contra-propagatives engendrant un déphasage relatif de ces ondes qui modifient leur état d'interférence lors de leur recombinaison.

La mesure de ce déphasage relatif permet de quantifier le phénomène qui l'a engendré.

Le principal phénomène physique susceptible de créer ces perturbations non réciproques est l'effet SAGNAC produit par la rotation de l'interféromètre par rapport à un axe perpendiculaire au plan de son chemin optique fermé. L'effet FARADAY ou effet magnéto-optique colinéaire est également connu comme produisant des effets non réciproques de ce type ; cela a par exemple été décrit dans un article de la revue OPTIC LETTERS (Vol. 7, n° 4, Avril 1982, pages 180-182) par K. BOHM. D'autres effets peuvent, dans certaines conditions produire également un déphasage non réciproque.

Au contraire, les variations de nombreux paramètres représentatifs de l'environnement qui sont souvent à l'origine de perturbations des mesures n'ont que des effets réciproques sur l'interféromètre de SAGNAC, ne perturbent pas le déphasage relatif entre les ondes contra-propagatives et n'ont donc pas d'influence sur la mesure du paramètre étudié. Tel est le cas des variations lentes de température, d'indices, etc... qui modifient le chemin optique parcouru par les ondes, mais le modifient de manière réciproque.

De nombreux travaux ont été menés afin d'améliorer la sensibilité et la précision des mesures pouvant être réalisées avec un tel appareil de mesure. On pourra par exemple consulter sur ce sujet le chapitre 9 intitulé "Fiber Optic Gyroscope" de Hervé C. Lefèvre dans l'ouvrage " Optical Fiber Sensors" VOL. 2 -ARTECH HOUSE- 1989.

En particulier, il a tout d'abord été constaté que la réponse fournie par l'interféromètre de SAGNAC est de la forme $P = Po(1 + \cos \delta\Phi)$ et donc que la sensibilité de ce signal au voisinage de la différence de phase $\delta\Phi = 0$ est faible. Il a été proposé d'introduire une modulation de différence de phase, carrée d'amplitude de plus ou moins $\pi/2$ par exemple qui déplace le point de fonctionnement et produit un signal périodique dont l'amplitude est une fonction sinusoïdale du paramètre mesuré et que l'on peut donc exploiter avec une plus grande sensibilité et stabilité (FR-2 555 739).

Il a ensuite été montré que la précision de la mesure est améliorée par l'utilisation d'une méthode de zéro également appelée fonctionnement en boucle fermée. Selon cette méthode, une différence de phase supplémentaire dite de contre-réaction $\delta\Phi_{cr}$ est appliquée et sert à compenser la différence de phase $\delta\Phi_p$ produit par le paramètre mesuré. La somme de ces deux différences de phase $\delta\Phi_{cr}$ et $\delta\Phi_p$, est maintenue nulle, ce qui permet de faire fonctionner l'interféromètre avec la précision maximum. La mesure est réalisée par l'exploitation du signal nécessaire à la production de la différence de phase de contre-réaction $\delta\Phi_{cr}$. Ainsi, la mesure est stable et linéaire.

L'asservissement nécessaire à ce fonctionnement en boucle fermée peut être réalisé par un décalage de fréquence. Ce décalage peut être généré directement à partir de modulateurs acousto-optiques ou bien simulé en appliquant une modulation serrodyne sur un modulateur de phase. Une telle modulation serrodyne est effectuée en appliquant une rampe de modulation de phase en dent de scie. Sur ce sujet on peut par exemple consulter le brevet US 4,299,490. Il est connu cependant que ceci nécessite une retombée bien contrôlée de $2\,\alpha\pi$ (où $\alpha$ est entier) pour éviter les bandes latérales parasites. L'exploitation du signal après les retombées permet cependant d'effectuer le contrôle de la valeur de la retombée pour assurer une bonne précision de la mesure (GB-A-2 152 207). Il est connu aussi qu'une rampe continue peut être remplacée par des marches synchronisées sur une horloge et qu'un tel signal peut être généré à partir d'un circuit logique et d'un convertisseur numérique-analogique (EP 0 168 292).

Afin d'améliorer la sensibilité et la précision de la mesure, il a, par ailleurs, été proposé de numériser le signal dès la sortie du détecteur. Les moyens électroniques de traitement comportent alors un convertisseur analogique-numérique, un système de traitement numérique exploitant le signal fourni par le convertisseur analogique-numérique ramenant sa composante à la fréquence de modulation autour du continu. Un filtre numérique de boucle d'asservissement alimenté par le signal sortant du système de traitement numérique, fournit un signal représentatif du paramètre mesuré. Un registre recevant le signal sortant du filtre numérique de boucle d'asservissement fournit un signal fonction du paramètre mesuré pour tout usage externe souhaité. Un accumulateur alimenté par le signal sortant du registre, génère une rampe numérique dont la pente est fonction du paramètre mesuré et un convertisseur numérique-analogique alimenté par le signal de rampe issu de l'accumulateur commande le modulateur de phase.

Le but de la présente invention est d'améliorer la sensibilité et la stabilité d'un dispositif de mesure à fibre optique tout en limitant la dynamique de la modulation, permettant ainsi, à performances égales, la diminution de la puissance d'alimentation du modulateur et donc la diminution de la dissipation thermique parasite qui l'accompagne. C'est également un objectif de l'invention de proposer un tel dispositif dans lequel le gain de la chaîne de commande de la modulation de contre-réaction est maintenu constant. A cet effet les signaux produits lors de la retombée de la rampe de phase sont utilisés.

L'invention concerne un dispositif de mesure à fibre optique dans lequel la variation du paramètre mesuré engendre une différence de phase entre deux ondes, comportant une source lumineuse quasi-monochromatique, un interféromètre en anneau de SAGNAC, de préférence monomode, dans lequel se propagent deux ondes contra-propagatives, le temps de propagation des ondes entre leur séparation et leur recombinaison étant $\tau$, un détecteur, un modulateur de phase, et des moyens électroniques comportant un système de traitement fournissant un signal fonction du paramètre mesuré et des moyens électroniques commandant le modulateur de phase

Le sont signal de commande du modulateur est la superposition d'un premier signal, de biais, périodique en créneaux générant un déphasage $\Phi_b(t)$ de période $2\tau$ et d'amplitude $\Phi_{bm}$ et d'un deuxième signal, de contre-réaction, en marches d'escalier générant un déphasage $\Phi_m(t)$ dont chaque marche a une durée égale à $\tau$ ou à l'un de ses sous-multiples, et une amplitude $\Phi_s$, fonction de la valeur du paramètre mesuré et qui retombe de $\Phi_{mm}$ lorsque son amplitude dépasse un seuil prédéterminé. Selon l'invention, $\Phi_{bm}$ et $\Phi_{mm}$ sont liées par la relation $2\Phi_{bm} + \Phi_{mm} = 2n\pi$ où n est un entier, la réponse au déphasage singulier introduit lors de la retombée du signal de contre-réaction étant utilisée pour maintenir constant le gain de la chaîne de modulation. De préférence, Ces déphasages $\Phi_b(t)$ et $\Phi_m(t)$ sont générés par un modulateur de phase placé à l'extrémité de la bobine et créent donc des différences de phase entre les 2 ondes contrapropagatives valant respectivement $\delta\Phi_b(t) = \Phi_b(t)-\Phi_b(t-$

$\tau$) et $\delta\Phi_m(t) = \Phi_m(t)-\Phi_m(t-\tau)$ qui s'additionnent.

De préférence, Les moyens électroniques de traitement du signal sont numériques et comportent un convertisseur analogique-numérique destiné à numériser le signal généré par le détecteur, un système à traitement numérique exploitant le signal fourni par le convertisseur analogique-numérique, un filtre numérique de boucle d'asservissement alimenté par le signal sortant du système de traitement numérique et fournissant un signal représentatif du paramètre mesuré, un registre recevant le signal sortant du filtre numérique de boucle d'asservissement et fournissant un signal fonction du paramètre mesuré pour tout usage externe souhaité, un accumulateur générant les marches à partir du signal du registre, un générateur de modulation produisant un signal de modulation, un additionneur comportant deux entrées et une sortie, sa première entrée étant alimentée par le signal fonction du paramètre mesuré produit par le registre et l'accumulateur, sa deuxième entrée étant alimentée par le signal de modulation de biais, un convertisseur numérique-analogique alimenté par le signal de sortie de l'additionneur et commandant le modulateur de phase.

L'invention sera décrite en détail en référence aux dessins dans lesquels :

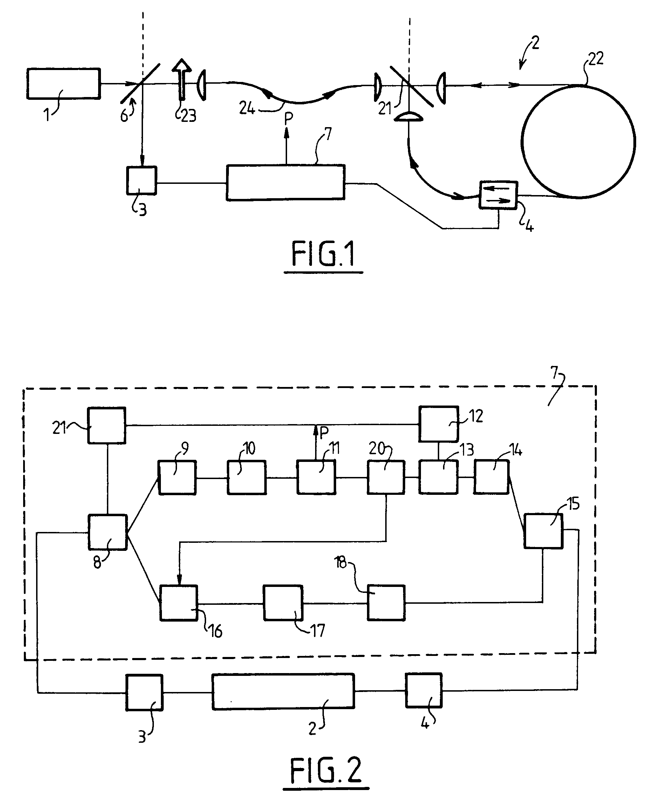

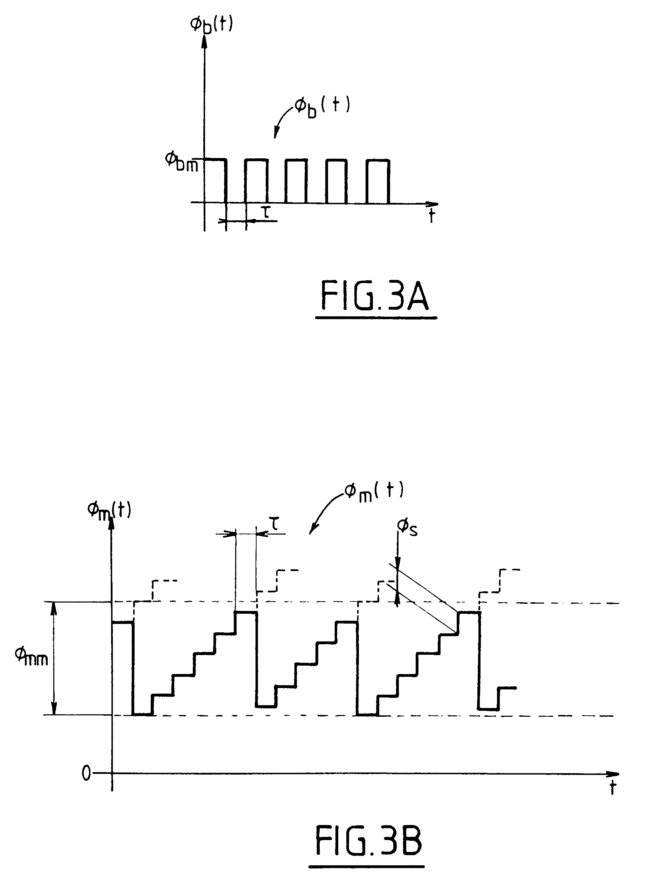

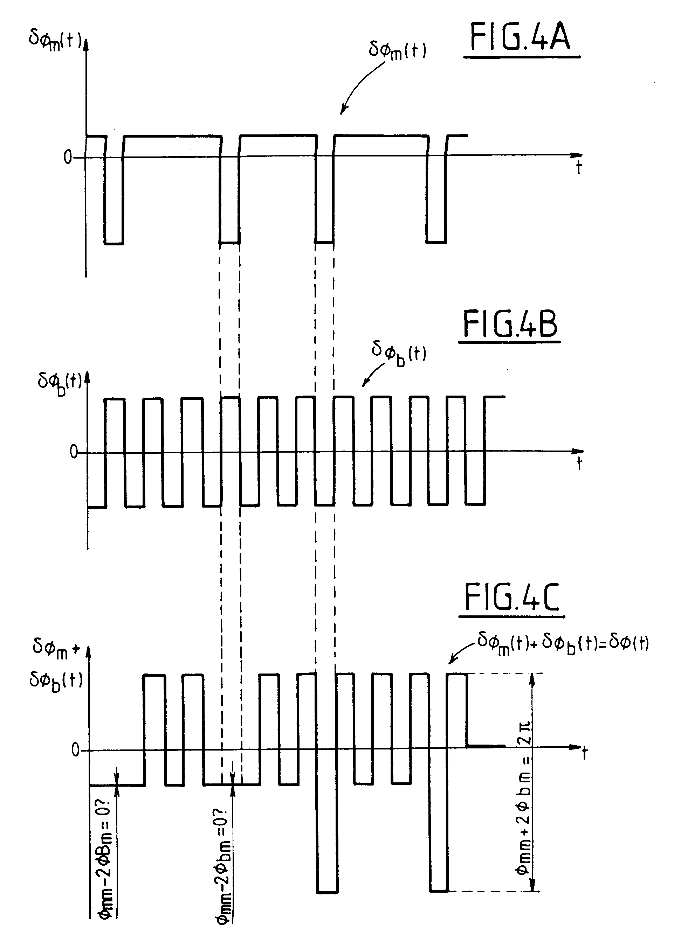

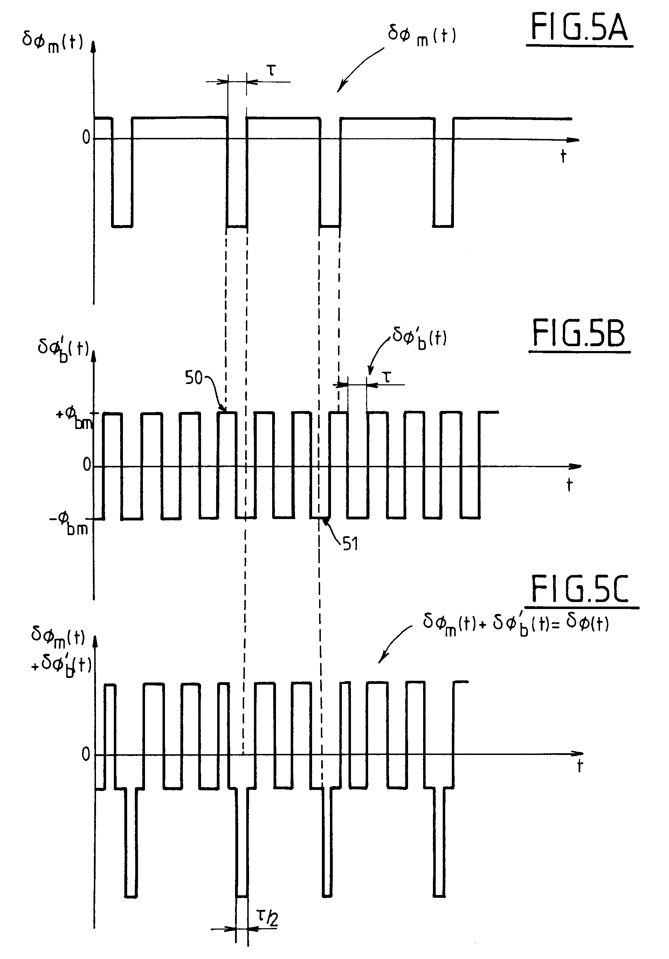

  . La figure 1 est une représentation générale du dispositif de mesure de l'invention.
  . La figure 2 est un schéma fonctionnel représentant le traitement du signal.
  . La figure 3 représente le premier signal $\Phi_b(t)$ (3A) périodique en créneaux et le deuxième signal $\Phi_m(t)$ (3B) en marches d'escalier utilisés pour la commande du modulateur.
  . La figure 4 représente la différence de phase $\delta\Phi(t)$ (4C) produite dans l'interféromètre par la superposition de $\delta\Phi_b(t)$ (4B) et $\delta\Phi_m(t)$ (4A) dans un premier mode de réalisation.
  . La figure 5 représente la différence de phase $\delta\Phi(t)$ (5C) produite dans l'interféromètre par la superposition de $\delta\Phi_b(t)$ (5B) et $\delta\Phi_m(t)$ (5A) dans un deuxième mode de réalisation.

Le dispositif de mesure à fibre optique de l'invention comporte une source lumineuse quasi-monochromatique 1 qui est le plus souvent un laser ou une diode super luminescente, un interféromètre en anneau de SAGNAC à fibre optique monomode globalement désigné par la référence 2.

Cet interféromètre en anneau 2 comporte une lame séparatrice 21 assurant la séparation des ondes à l'entrée de l'interféromètre puis leur recombinaison à la sortie, un chemin optique fermé 22 constitué par une fibre optique monomode enroulée sur elle-même. Le temps de propagation des ondes entre leur séparation et leur recombinaison est $\tau$.

Ce dispositif de mesure comporte également un détecteur 3 fournissant un signal fonction de l'état d'interférence des ondes à la sortie de l'interféromètre lui-même.

Le signal optique est fourni au détecteur 3 par l'intermédiaire d'un séparateur 6 par exemple constitué d'une lame semi-transparente.

A l'une des extrémités du chemin optique de l'interféromètre est interposé un modulateur 4, qui commandé à partir d'un signal électrique, génère un déphasage $\Phi(t)$ qui est susceptible d'introduire une différence de phase $\delta\Phi(t) = \Phi(t) - \Phi(t-\tau)$ entre les deux ondes. Le fonctionnement de l'interféromètre est amélioré en interposant entre la source lumineuse 1 et l'entrée de l'anneau 22, c'est-à-dire la lame séparatrice 21, un polarisateur 23 et un filtre spatial 24. De manière connue, ce filtre spatial est constitué par une fibre optique monomode.

Des moyens électroniques numériques 7 commandent en contre-réaction le modulateur de phase 4 en fonction du signal reçu du détecteur 3.

Ces moyens électroniques numériques 7 sont configurés de telle sorte que la variation du signal d'erreur démodulé en fonction de la différence de marche produite entre les deux ondes au voisinage du zéro soit approximativement linéaire. Cette disposition permet d'obtenir une très bonne sensibilité de la variation du signal d'erreur démodulé au voisinage du zéro de la différence de marche alors qu'il est aisément compréhensible que lorsque la dépendance du signal par rapport à la différence de marche est de forme cosinusoïdale la sensibilité au voisinage de zéro de la différence de marche est très faible. Cela est obtenu en appliquant au signal de commande du modulateur de phase un signal de modulation de biais $\Phi_b(t)$. Le signal est un signal périodique, en créneaux de période égale à $2\tau$ et d'amplitude maximum $\Phi_{bm}$.

Les moyens électroniques numériques 7 ont également pour fonction de maintenir la différence de marche nulle. C'est-à-dire que lorsque la variation du paramètre mesuré introduit une différence de phase entre les deux ondes dans l'interféromètre, cette différence produit une variation du signal émis par le détecteur 3 entraînant par l'intermédiaire des moyens électroniques numériques 7 et du modulateur de phase 4 une action égale et de sens inverse au déphasage initialement produit de telle sorte que la différence de phase globale est ramenée à la valeur nulle.

A cette fin, les moyens électroniques 7 génèrent un signal de contre-réaction $\Phi_m(t)$, en marches d'escalier. Chaque marche a une durée égale à $\tau$ ou à l'un de ses sous-multiples et une amplitude $\Phi_s$ fonction de la valeur du paramètre mesuré. Il retombe de la valeur $\Phi_{mm}$ lorsque son amplitude dépasse un seuil prédéterminé.

Le signal de modulation de biais $\Phi_b(t)$ et le signal de modulation de contre-réaction $\Phi_m(t)$ sont ensuite superposés pour commander le modulateur de phase 4. La retombée du signal de modulation de contre-réaction $\Phi_m(t)$ est donc produite avant sa superposition au signal de modulation de biais $\Phi_b(t)$.

Il a été constaté qu'il est particulièrement avantageux de relier les paramètres $\Phi_{bm}$ et $\Phi_{mm}$ par la relation $2\Phi_{bm} + \Phi_{mm} = 2n\pi$. La mesure ainsi obtenue est particulièrement stable et la retombée du signal de contre-réaction est avantageusement utilisée pour maintenir constant le gain de la chaîne de modulation sans qu'il soit nécessaire que la dynamique de la mesure soit importante.

Enfin, ces moyens électroniques numériques 7 fournissent par exploitation du signal $\Phi_m(t) + \Phi_b(t)$ de commande du modulateur de phase 4 un signal fonction de la variation du paramètre mesuré.

Le temps de propagation des ondes entre leur séparation et leur recombinaison est $\tau$.

Les moyens électroniques numériques 7 comportent un convertisseur analogique-numérique 8 destiné à numériser le signal émis par le détecteur 3.

La dynamique du convertisseur analogique-numérique 8 peut être relativement faible par rapport à la dynamique de mesure de l'ensemble. Cette dynamique se détermine à partir de la définition de la limite basse et de la limite haute.

La limite basse est déterminée de telle sorte que la valeur analogique correspondant au bit de poids faible ait une valeur inférieure ou égale à l'écart type du bruit du signal venant du détecteur. Cette condition évite une zone aveugle correspondant au bit de poids faible, et rend négligeable le bruit d'échantillonnage par rapport au bruit initial du signal analogique. De plus, un filtrage numérique additionnel conduit dans ce cas à la même amélioration du rapport signal à bruit qu'en analogique. Selon un exemple pratique, la période d'échantillonnage est de l'ordre du temps de transit dans la bobine soit par exemple $\tau = 0,5\mu s$ pour 100 mètres de fibre. Le critère de Shannon impose donc une bande passante importante au signal à échantillonner : il faut qu'elle soit égale à $1/2\tau$ soit 1MHz dans cet exemple. Dans une telle bande passante le bruit est relativement important : typiquement un écart-type de $10^{-3}$ de la puissance retour au biais ce qui correspond à environ un déphasage de $10^{-3}$ radian dans l'interféromètre. Il est donc suffisant que le bit de poids faible corresponde à ce déphasage pour ne pas perdre de sensibilité et pour pouvoir ensuite par filtrage numérique améliorer le rapport signal à bruit.

La limite haute, quant à elle, doit être au moins supérieure à la valeur pic à pic du bruit soit environ 8 fois son écart-type et donc 3 bits suffiraient pour l'échantillonnage du bruit seul. Cependant, il faut aussi tenir compte de la dynamique propre du signal : en boucle fermée celui-ci est asservi à zéro et ne réclamerait donc pas a priori de dynamique mais en pratique l'asservissement s'écarte de zéro lors de variations brusques du paramètre à mesurer et la dynamique du convertisseur doit pouvoir supporter ces écarts. Ces variations définissent donc le nombre de bits nécessaires. En pratique 8 à 12 bits suffisent au niveau du convertisseur alors qu'après filtrage numérique la dynamique du paramètre mesuré peut être supérieure à 20 bits.

L'horloge 21 pilote l'ensemble de ces composants.

Un système à traitement numérique 9 exploite le signal fourni par le convertisseur analogique-numérique 8 en faisant la différence entre les échantillons correspondant à une modulation de biais de la différence de phase $\delta\Phi_b(t) = \Phi_{bm}$ et ceux correspondant à $\delta\Phi_b(t) = -\Phi_{bm}$. Il est suivi d'un filtre numérique intégrateur de boucle d'asservissement 10 alimenté par le signal sortant du système de traitement numérique 9 et fournissant, après élimination de la modulation de biais, un signal représentatif du paramètre mesuré.

Un registre 11 reçoit le signal sortant du filtre numérique de boucle d'asservissement et fournit un signal fonction du paramètre mesuré utilisable pour tout usage externe souhaité.

L'unité 20 produit le signal de modulation de contre-réaction $\Phi_m(t)$ à partir de la valeur du paramètre mesuré.

Un générateur de modulation 12 produit le signal de modulation de biais $\Phi_b(t)$.

L'additionneur 13 comporte deux entrées et une sortie. Sa première entrée est alimentée par un signal de contre-réaction fonction du paramètre mesuré produit par le registre 11 et l'unité 20, sa deuxième entrée est alimentée par le signal de modulation produit par le générateur 12. Son signal de sortie est donc $\Phi_m(t) + \Phi_b(t)$.

Un convertisseur numérique-analogique 14 alimenté par le signal de sortie de l'additionneur 13 commande le modulateur de phase 4 par l'intermédiaire de l'amplificateur de gain 15. Le signal produit par le générateur 12 assure le fonctionnement du système de mise au biais c'est-à-dire une dépendance approximativement linéaire entre le déphasage introduit entre les deux ondes contrapropagatives circulant dans l'interféromètre et le signal produit dans le détecteur 3.

Dans un premier mode de réalisation (figure 4), en fonctionnement normal, le système de traitement 7 génère le signal de modulation de biais $\Phi_b(t)$ et le signal de modulation de contre-réaction $\Phi_m(t)$ composé de marches de durée $\tau$ d'amplitude $\Phi_s$. $\Phi_b(t)$ et $\Phi_m(t)$ sont en phase, c'est-à-dire qu'ils sont simultanément constants pendant le même intervalle de temps de durée $\tau$.

Le signal de biais crée dans l'interféromètre une modulation de biais $\delta\Phi_b(t) = \Phi_b(t) - \Phi_b(t-\tau)$ de la différence de phase. Cette modulation $\delta\Phi_b(t)$ varie en créneau entre $+\Phi_{bm}$ et $-\Phi_{bm}$, avec une période de $2\tau$.

Le signal de contre-réaction $\Phi_m(t)$ crée une différence de phase $\delta\Phi_m(t)$ constante égale à $a\Phi_s$ pour des marches de durée $\tau/a$ (où a est un entier supérieur ou égal à 1). Mais par débordement du registre numérique de dynamique $\Phi_{mm}$, la rampe $\Phi_m(t)$ retombe. Pendant un temps $\tau$ après cette retombée, la modulation de contre-réaction de la différence de phase $\delta\Phi_m(t) = \Phi_m(t) - \Phi_m(t-\tau)$ devient égale à $a\Phi_s - \Phi_{mm}$ au lieu de $a\Phi_s$. Il est connu que pour éviter des signaux parasites, il suffit que $\Phi_{mm}$ corresponde à $2\pi$, la périodicité des interférences. Il a été constaté que cette condition connue n'est pas strictement nécessaire et qu'il est avantageux de réduire la valeur de cette retombée et donc de limiter la puissance consommée dans le modulateur ainsi que la dissipation thermique associée. En effet, cette retombée $\Phi_{mm}$ est associée au signal de modulation de biais $\Phi_b(t)$. En se plaçant dans le cas où a = 1 par exemple, c'est-à-dire que les marches ont une durée $\tau$, il a été constaté que la différence de phase $\delta\Phi_b(t) + \delta\Phi_m(t)$ prend de chaque côté d'une retombée les valeurs :

$$\delta\Phi_1 = \Phi_s + \Phi_{bm} \text{ et } \delta\Phi_2 = \Phi_s - \Phi_{bm} - \Phi_{mm}$$

ou bien

$$\delta\Phi_1 = \Phi_s - \Phi_{bm} \text{ et } \delta\Phi'_2 = \Phi_s + \Phi_{bm} - \Phi_{mm}$$

La différence entre ces valeurs est donc respectivement :

$$\delta\Phi_1 - \delta\Phi_2 = \Phi_{mm} + 2\Phi_{bm}$$

ou bien :

$$\delta\Phi'_1 - \Phi'_2 = \delta\Phi_{mm} - 2\Phi_{bm}$$

Il a été constaté qu'en choisissant $\Phi_{mm} = 2\Phi_{bm}$ dans la conception du circuit logique de traitement, on s'assure que $\delta\Phi'_1 - \delta\Phi'_2 = 0$, ce qui évite tout signal parasite dans ce cas. Et il est possible d'asservir $\delta\Phi_1 - \delta\Phi_2$ et donc $\Phi_{mm} + 2\Phi_{bm}$ sur $2\pi$, pour éviter les signaux parasites dans le deuxième cas et aussi pour asservir le gain de la chaîne de modulation. Ceci peut être réalisé avec un système de traitement 16 qui effectue la différence entre le signal échantillonné par le convertisseur 8 avant la retombée et celui échantillonné après. Cette différence fournit un signal d'erreur qui s'annule quand $\delta\Phi_1 - \delta\Phi_2 = \Phi_{mm} + 2\Phi_{bm} = 2n\pi$.

Ce signal d'erreur élaboré à partir du système 16 est envoyé dans un deuxième filtre intégrateur de boucle d'asservissement 17. Le signal numérique issu de ce filtre numérique est alors restitué en analogique dans un deuxième convertisseur numérique-analogique 18 qui commande le gain de l'amplificateur 15 (tel que représenté sur la figure 2) ou bien la tension de référence du convertisseur 14 (non représenté). Cette deuxième boucle asservit le gain de la chaîne de modulation et conduit donc à assurer une mesure précise de la valeur de la marche $\Phi_s$ générée dans la première boucle de contre-réaction. Cette marche $\Phi_s$ étant opposée à la différence de phase $\delta\Phi_p/a$ dépendant du paramètre à mesurer, ceci conduit à une mesure précise de ce dernier.

Dans un deuxième mode de réalisation (figure 5) le système de traitement 7 génère le signal de modulation de biais $\Phi_b(t)$ et le signal de modulation de contre-réaction $\Phi_m(t)$ composé de marches de durée $\tau$, d'amplitude $\Phi_s$ et la synchronisation de $\Phi_m(t)$ avec $\Phi_b(t)$ est retardée de $\tau/2$.

Le signal de biais crée dans l'interféromètre une modulation de biais $\delta\Phi_b(t) = \Phi_b(t)-\Phi_b(t-\tau)$ de la différence de phase. Cette modulation $\delta\Phi_b(t)$ varie en le créneau entre $+\Phi_{bm}$ et $-\Phi_{bm}$, avec une période de $2\tau$.

Le signal de contre-réaction $\Phi_m(t)$ crée une différence de phase $\delta\Phi_m(t)$ constante égale à $\Phi_s$ pour des marches de durée $\tau$. Mais par débordement du registre numérique de dynamique $\Phi_{mm}$ la rampe $\Phi_m(t)$ retombe. Pendant un temps $\tau$ après cette retombée la modulation de contre-réaction de la différence de phase $\delta\Phi_m(t) = \Phi_m(t)-\Phi_m(t-\tau) = a\Phi_s-\Phi_{mm}$ au lieu de $a \Phi_s$ avant cette retombée.

A cause du retard $\tau/2$ de synchronisation entre $\Phi_b(t)$ et $\Phi_m(t)$, la retombée de $\Phi_m(t)$ a lieu au milieu du niveau $+\Phi_{bm}$ ou bien au milieu du niveau $-\Phi_{bm}$ de $\delta\Phi_b(t)$ (repères 50 et 51 sur la figure 5B). Pendant une durée $\tau$ avant la retombée, $\delta\Phi$ (t) prend toujours 2 valeurs de durée $\tau/2$ chacune :

$$\delta\Phi_1 = \Phi_s + \Phi_{bm}$$
$$\delta\Phi'_1 = \Phi_s - \Phi_{bm}$$

Pendant une durée $\tau$ après la retombée, $\delta\Phi(t)$ prend toujours 2 valeurs de durée $\tau/2$ chacune :

$$\delta\Phi_2 = \Phi_s - \Phi_{bm} - \Phi_{mm}$$
$$\delta\Phi'_2 = \Phi_s + \Phi_{bm} - \Phi_{mm}$$

Si la retombée a lieu au milieu du niveau $+ \Phi_{bm}$ les 4 états successifs de $\delta\Phi(t)$ de durée $\tau/2$ entourant cette retombée seront :

$$\delta\Phi'_1, \delta\Phi_1, \delta\Phi'_2 \text{ et } \delta\Phi_2$$

Si la retombée a lieu au milieu du niveau $-\Phi_{bm}$ les 4 états successifs de $\delta\Phi(t)$ de durée $\tau/2$ entourant cette retombée seront alors :

$$\delta\Phi_1, \delta\Phi'_1, \delta\Phi_2 \text{ et } \delta\Phi'_2$$

Il a été constaté qu'en choisissant $\Phi_{mm} = 2 \Phi_{bm}$ il fallait que le système de traitement 16 effectue l'opération :

échantillon 1 + échantillon 2 - échantillon 3 - échantillon 4.

Cette opération génère dans les deux cas un signal d'erreur qui s'annule quand :

$$\delta\Phi_1 - \delta\Phi_2 = \Phi_{mm} + 2\Phi_{bm} = 2n\pi$$

car

$$\delta\Phi'_1 - \delta\Phi'_2 = 0 \text{ quand } \Phi_{mm} = 2\Phi_{bm}$$

Cette opération fournit donc un signal d'erreur analogue à celui obtenu dans le premier mode de réalisation décrit en référence à la figure 4.

Ce signal d'erreur élaboré à partir du système 16 est traité de même manière que dans le mode de réalisation décrit précédemment de manière à asservir le gain de la chaîne de modulation.

Notons que dans ce deuxième mode de réalisation l'échantillonage du signal provenant du détecteur doit avoir lieu avec une période de $\tau/2$ et non plus de $\tau$.

Le dispositif de mesure de l'invention est particulièrement bien adapté à la réalisation d'un gyromètre. Dans ce cas, le paramètre mesuré est la vitesse de rotation de l'interféromètre autour de son axe.

Ce gyromètre entre avantageusement dans la réalisation de centrales de navigation ou de stabilisation inertielle.

Une telle disposition est également bien adaptée à la réalisation du dispositif de mesure de champs magnétiques et de courant électrique en mettant à profit l'effet FARADAY.

## Revendications

1. Dispositif de mesure à fibre optique du type dans lequel la variation d'un paramètre mesuré engendre une différence de phase entre deux ondes, comportant :

   - une source lumineuse quasi-monochromatique (1),
   - un interféromètre en anneau de Sagnac (2), de préférence monomode, dans lequel se propagent deux ondes contrapropagatives, le temps de propagation des ondes entre leur séparation et leur recombinaison étant $\tau$,

- un détecteur (3),
- un modulateur de phase (4),
- des moyens électroniques (7) comportant un système de traitement (9) fournissant un signal fonction du paramètre mesuré, et des moyens électroniques (12) commandant le modulateur de phase (4), dans lequel le signal de commande du modulateur est la superposition d'un premier signal, de biais, périodique en créneaux $\Phi_b(t)$ de période $2\tau$ et d'amplitude $\Phi_{bm}$, et d'un deuxième signal, de contre-réaction, en marches d'escalier $\Phi_m(t)$ synchronisé avec $\Phi_b(t)$, dont chaque marche a une durée égale à $\tau$ ou à l'un de ses sous-multiples, et une amplitude $\Phi_s$, fonction de la valeur du paramètre mesuré, qui retombe à zéro lorsque son amplitude dépasse une valeur prédéterminée $\Phi_{mm}$,

caractérisé en ce que $\Phi_{bm}$ et $\Phi_{mm}$ sont asservies à $2\Phi_{bm} + \Phi_{mm} = 2n\pi$ où n est un entier, la réponse au déphasage singulier introduit lors de la retombée du signal de contre-réaction étant utilisée pour maintenir constant le gain de la chaîne de modulation.

2. Dispositif de mesure à fibre optique selon la revendication 1, caractérisé en ce que les moyens électroniques (7) commandent en contre-réaction le modulateur de phase (4) en fonction du signal reçu du détecteur (3) de telle sorte que d'une part la variation du signal d'erreur démodulé en fonction de la différence de phase au voisinage du zéro soit approximativement linéaire, que d'autre part cette différence de phase soit maintenue nulle et fournissant par exploitation du signal de modulation (4) un signal fonction de la variation du paramètre mesuré, et qu'ils comportent, en plus du système de traitement (9) :
    - une horloge synchronisant l'ensemble des composants,
    - un convertisseur analogique-numérique (8) destiné à numériser le signal émis par le détecteur (3), le convertisseur analogique-numérique (8) étant déterminé de telle sorte que la valeur analogique de son bit de poids faible ait une valeur inférieure ou égale à l'écart-type du bruit du signal venant du détecteur.
    - un filtre numérique de boucle d'asservissement (10), alimenté par le signal sortant du système de traitement numérique (9), fournissant un signal représentatif du paramètre mesuré,
    - un registre (11) recevant le signal sortant du filtre numérique de boucle d'asservissement et fournissant un signal fonction du paramètre mesuré pour tout usage externe souhaité,
    - un accumulateur (20) alimenté par le signal sortant du registre (11), générant un signal de contre-réaction du paramètre mesuré, $\Phi_m(t)$.
    - un générateur de modulation (12) produisant un signal de modulation $\Phi_b(t)$
    - un additionneur (13) comportant deux entrées, et une sortie, sa première entrée étant alimentée par le signal fonction du paramètre mesuré produit par le registre et l'accumulateur, sa deuxième entrée étant alimentée par le signal de modulation,
    - un convertisseur numérique-analogique (14) alimenté par le signal de sortie de l'additionneur et commandant le modulateur de phase (4) par l'intermédiaire d'un amplificateur de gain (15).
    - un système de traitement (16) qui effectue la différence entre le signal échantillonné par le convertisseur 8 avant la retombée et celui échantillonné après.
    - un deuxième filtre intégrateur de boucle d'asservissement 17 recevant le signal issu du système de traitement 16.
    - un deuxième convertisseur analogique-numérique 18 qui commande le gain de l'amplificateur 15.

3. Dispositif de mesure à fibre optique selon la revendication 1, caractérisé en ce que $\Phi_b(t)$ et $\Phi_m(t)$ sont en phase.

4. Dispositif de mesure à fibre optique selon la revendication 1, caractérisé en ce que $\Phi_b(t)$ est retardée de $\tau/2$ par rapport à $\Phi_m(t)$.

5. Dispositif de mesure à fibre optique selon l'une quelconque des revendications 1 à 4, caractérisé en ce que $\Phi_{bm} = \pi/2$ et $\Phi_{mm} = \pi$.

6. Gyromètre, caractérisé en ce qu'il est conforme au dispositif de mesure de l'une quelconque des revendications 1 à 5, le paramètre mesuré étant la vitesse de rotation de l'interféromètre autour de son axe.

7. Centrale de navigation ou de stabilisation inertielle comportant au moins un gyromètre selon la revendication 6.

8. Capteur de courant et de champ magnétique, caractérisé en ce qu'il est conforme au dispositif de mesure de l'une quelconque des revendications 1 à 5, la variation de la différence de marche étant produite par le paramètre mesuré par effet FARADAY.

## Claims

1. A fiber optic measuring device in which the variation in a measured parameter provides a phase difference between two waves, comprising:
   - a quasi-monochromatic light source (1),
   - a preferably monomode, SAGNAC ring interferometer (2) in which two counter-propagating waves propagate, the propagation time of the waves between their splitting and their recombining being $\tau$,
   - a detector (3),
   - a phase modulator (4)
   - electronic means (7) comprising a processing system (9) giving a signal which is a function of the measured parameter and electronic means (12) controlling the phase modulator (4), wherein the control signal for the modulator is the superposition of a first, periodic gating, bias signal $\phi_b$ (t) with period $2\tau$ and amplitude $\phi_{bm}$, and of a second, staircase, negative-feedback signal $\phi_m$ (t) synchronized with $\phi_b$ (t), each step of which has a duration equal to $\tau$ or to one of its sub-multiples, and an amplitude $\phi_{s'}$ which is a function of the value of the measured parameter and which falls back to zero when its amplitude exceeds a predetermined value $\phi_{mm'}$ characterized in that $\phi_{bm}$ and $\phi_{mm}$ are slaved to 2 $\phi_{bm}$ + $\phi_{mm}$ = 2 n$\pi$ where n is an integer, the response to the singular phase shift introduced during the fall-back of the negative-feedback signal being used to keep the gain of the modulation chain constant.

2. The fiber optic measuring device according to claim 1, characterized in that the electronic means (7) negative-feedback control the phase modulator (4) as a function of the signal received from the detector (3) so that, on the one hand, the variation in the demodulated error signal as a function of the phase difference in the neighborhood of zero is approximately linear, and on the other hand, this phase difference is kept null and giving, by exploiting the modulating signal (4) a signal which is a function of the variation in the measured parameter, and in that they comprise, in addition to the processing system (9):
   - a clock synchronizing all the components,
   - an analog-digital converter (8) intended to digitize the signal emitted by the detector (3), the analog-digital converter (8) being specified so that the analog value of its least significant bit has a value less than or equal to the standard deviation of the noise in the signal coming from the detector,
   - a servo-loop digital filter (10), fed by the signal, leaving the digital processing system (9), giving a signal representing the measured parameter,
   - a register (11) receiving the signal leaving the servo-loop digital filter and giving a signal which is a function of the measured parameter for any desired external use,
   - an accumulator (20) fed by the signal leaving the register (11), generating a negative feedback signal from the measured parameter $\phi_m$(t),
   - a modulation generator (12) producing a modulating signal $\phi_b$(t),
   - an adder (13) comprising two inputs and one output, its first input being fed by the signal which is a function of the measured parameter produced by the register and the accumulator, its second input being fed by the modulating signal,
   - a digital-analog converter (14) fed by the output signal from the adder and controlling the phase modulator (4) via a gain amplifier (15)
   - a processing system (16) which produces the difference between the signal sampled by the converter (8) before the fall-back and that sampled after,
   - a second servo-loop integrating filter (17) receiving the signal issuing from the processing system (16),
   - a second analog-digital converter (18) which controls the gain of the amplifier (15).

3. The fiber optic measuring device according to claim 1, characterized in that $\phi_b$(t) and $\phi_m$(t) are in phase.

4. The fiber optic measuring device according to claim 1, characterized in that $\phi_b$(t) is delayed by $\tau/2$ relative to $\phi_m$(t).

5. The fiber optic measuring device according to any one of claims 1 to 4, characterized in that $\phi_{bm} = \pi/2$ and $\phi_{mm} = \pi$.

6. Rate gyro, characterized in that it corresponds to the measuring device according to any one of claims 1 to 5, the measured parameter being the rotation speed of the interferometer about its axis.

7. Inertial stabilization or navigation system comprising at least a rate gyro according to claim 6.

8. Magnetic field and current sensor, characterized in that it corresponds to the measuring device according to any one of claims 1 to 5, the variation of the function difference being produced by the parameter measured by Faraday effect.

**Patentansprüche**

1. Faseroptische Meßvorrichtung des Typs, bei dem die Veränderung eines gemessenen Parameters eine Phasendifferenz zwischen zwei Wellen erzeugt, mit:
   - einer quasi-monochromatischen Lichtquelle (1),
   - einem vorzugsweise monomodalen Sagnac-Ringinterferometer, in dem sich zwei sich in entgegengesetzten Richtungen ausbreitende Wellen ausbreiten, wobei die Ausbreitungszeit der Wellen zwischen ihrer Trennung und ihrer Rekombination mit $\tau$ bezeichnet ist,
   - einem Detektor (3),
   - einem Phasenmodulator (4),
   - einer elektronischen Einrichtung (7) mit einem Verarbeitungssystem (9), das ein Signal als Funktion des gemessenen Parameters liefert, und einer den Phasenmodulator (4) steuernden elektronischen Einrichtung (12), wobei das Modulatorsteuersignal die Überlagerung eines ersten periodischen Verschiebungs-Rechtecksignals $\Phi_b(t)$ mit der Periode $2\tau$ und der Amplitude $\Phi_{bm}$ mit einem zweiten Gegenreaktions-Treppenstufensignal $\Phi_m(t)$ ist, das mit $\Phi_b(t)$ synchronisiert ist, wobei jede Stufe eine Dauer von $\tau$ oder einem seiner Untervielfachen hat und eine Amplitude $\Phi_s$ aufweist, welche eine Funktion des Wertes des gemessenen Parameters ist, und das auf Null fällt, wenn seine Amplitude einen vorbestimmten Wert $\Phi_{mm}$ übersteigt,
   dadurch gekennzeichnet, daß $\Phi_{bm}$ und $\Phi_{mm}$ auf $2\Phi_{bm} + \Phi_{mm} = 2 n\pi$ gesteuert sind, wobei n eine ganze Zahl ist, und wobei die Antwort auf die beim Zurückfallen des Gegenreaktionssignals auf Null verursachte singuläre Phasenverschiebung zum Konstanthalten der Verstärkung der Modulationskette verwendet wird.

2. Faseroptische Meßvorrichtung nach Anspruch 1, dadurch gekennzeichnet, daß die elektronische Einrichtung (7) den Phasenmodulator (4) in Abhängigkeit von dem vom Detektor (3) empfangenen Signal derart in Gegenreaktion steuert, daß einerseits die Schwankung des demodulierten Fehlersignals als Funktion der Phasendifferenz nahe Null ungefähr linear ist und daß andererseits diese Phasendifferenz auf Null gehalten wird und wobei unter Verwendung des Modulationssignals (4) ein von der Veränderung des gemessenen Parameters abhängiges Signal erzeugt wird, und daß sie neben dem Verarbeitungssystem (9) ferner aufweist:
   - einen sämtliche Elemente synchronisierenden Taktgeber,
   - einen Analog/Digital-Wandler (8) zum Digitalisieren des von dem Detektor (3) ausgegebenen Signals, wobei der Analog/Digital-Wandler (8) derart ausgelegt ist, daß der Analogwert seines geringwertigen Bits geringer oder gleich dem Wert des typischen Rauschabstands des Signals des Detektors ist,
   - einen mit dem vom Digitalverarbeitungssystem (9) ausgegebenen Signal gespeisten Digitalfilter-Regelkreis (10) zum Liefern eines Signals, das den gemessenen Parameter repräsentiert,
   - ein Register (11), das das Ausgangssignal des Digitalfilter-Regelkreises (10) empfängt und ein von dem gemessenen Parameter abhängiges Signal für jeglichen externen Verwendungszweck liefert,
   - einen von dem Ausgangssignal des Registers (11) gespeisten Akkumulator (20), der ein Gegenreaktionssignal $\Phi_m(t)$ zum gemessenen Parameter erzeugt,
   - einen ein Modulationssignal $\Phi_b(t)$ erzeugenden Modulations generator (12),
   - einen Addierer (13) mit zwei Eingängen und einem Ausgang, an dessen erstem Eingang das von dem Register und dem Akkumulator erzeugte, von dem gemessenen Parameter abhängige Signal anliegt, wobei an seinem zweiten Eingang das Modulationssignal anliegt,
   - einen Digital/Analog-Wandler (14), dem das Ausgangssignal des Addierers zugeführt wird und der den Phasenmodulator (4) über einen Verstärker (15) steuert,
   - ein Verarbeitungssystem (16), das die Differenz zwischen dem vom Wandler (8) vor der Rückkehr nach Null abgetasteten Signal und dem danach abgetasteten Signal bildet,

- einen zweiten Integrationsfilter-Regelkreis (17), der das Ausgangssignal des Verarbeitungssystems (16) empfängt,
- einen zweiten Analog/Digital-Wandler (18), der die Verstärkung des Verstärkers (15) steuert.

3. Faseroptische Meßvorrichtung nach Anspruch 1, dadurch gekennzeichnet, daß $\Phi_b(t)$ und $\Phi_m(t)$ in Phase sind.

4. Faseroptische Meßvorrichtung nach Anspruch 1, dadurch gekennzeichnet, daß $\Phi_b(t)$ gegenüber $\Phi_m(t)$ um $\tau/2$ verzögert ist.

5. Faseroptische Meßvorrichtung nach einem der Ansprüche 1-4, dadurch gekennzeichnet, daß $\Phi_{bm} = \pi/2$ und $\Phi_{mm} = \pi$ ist.

6. Gyrometer, dadurch gekennzeichnet, daß es der Meßvorrichtung nach einem der Ansprüche 1 bis 5 entspricht, wobei der gemessene Parameter die Drehgeschwindigkeit des Interferometers um seine Achse ist.

7. Trägheitsnavigations- oder -stabilisierungszentrale mit wenigstens einem Gyrometer nach Anspruch 6.

8. Strom- und Magnetfeldsensor, dadurch gekennzeichnet, daß er der Meßvorrichtung nach einem der Ansprüche 1 bis 5 entspricht, wobei die Stufendifferenz durch den mit Hilfe des Faraday-Effekts gemessenen Parameter erzeugt wird.

EP 0 455 530 B1

FIG.1

FIG.2

$\phi_b(t)$

$\phi_b(t)$

$\phi_{bm}$

$\tau$

$t$

## FIG.3A

$\phi_m(t)$

$\phi_m(t)$

$\tau$

$\phi_S$

$\phi_{mm}$

0

$t$

## FIG.3B

FIG.4A

FIG.4B

FIG.4C

FIG.5A

FIG.5B

FIG.5C